# EUROPEAN PATENT APPLICATION

(11) **EP 4 239 673 A1**
(43) Date of publication of application: **06.09.2023**
(21) Application number: 21896651.3
(22) Date of filing: 21.10.2021
(51) Int. Cl.: H01L 23/495, H01L 21/50

(54) **PACKAGING STRUCTURE AND PACKAGING METHOD**

(30) Priority: 30.11.2020 CN 202011375308
(71) Applicant: Huawei Technologies Co., Ltd., Shenzhen, Guangdong 518129 (CN)
(72) Inventor: LIN, Yanhai, Shenzhen, Guangdong 518129 (CN); HUANG, Mingli, Shenzhen, Guangdong 518129 (CN); ZHANG, Xiaomin, Shenzhen, Guangdong 518129 (CN); HUANG, An, Shenzhen, Guangdong 518129 (CN); YANG, Guanqiao, Shenzhen, Guangdong 518129 (CN)
(74) Representative: MERH-IP Matias Erny Reichl Hoffmann Patentanwälte PartG mbB
(86) International application number: PCT/CN2021/125213
(87) International publication number: WO 2022/111149

(57) **Abstract**

This application discloses a package structure and a package method. The package structure may include a package substrate. The package substrate may be configured to bear a die. A printed circuit board may be disposed on the package substrate. The printed circuit board includes a board body and a metal pin on the board body. The board body is of an annular structure. The metal pin extends horizontally outside the board body and is configured to connect to an external circuit. The metal pin is further configured to connect to the die when the die is disposed on the package substrate exposed by the board body. In other words, in embodiments of this application, a package frame and a pin may be a printed circuit board. The printed circuit board includes a metal pin that may extend outside a board body, to implement an electrical connection between a die and an external circuit. Because manufacturing of the printed circuit board is simple, package costs are low. Because the package frame and the pin form an integrated structure, a package process is simplified.

## Description

This application claims priority to Chinese Patent Application No. 202011375308.6, filed with the China National Intellectual Property Administration on November 30, 2020 and entitled "PACKAGE STRUCTURE AND PACKAGE METHOD", which is incorporated herein by reference in its entirety.

### TECHNICAL FIELD

This application relates to the field of packaging technologies, and in particular, to a package structure and a package method.

### BACKGROUND

In an actual operation, a die (die) needs to be packaged to form a complete component. Functions of a package structure for packaging the die include: (1) implementing an electrical connection, to be specific, connecting an internal circuit of the die to an external circuit, where this function is mainly implemented by using a pin; (2) providing physical protection for the die to prevent damage that is inside the component and that is caused by mechanical contact during turnover, circuit assembly, and actual working; and (3) ensuring, as a carrier for conducting electricity and heat, that a coefficient of thermal expansion matches well, buffering impact of a thermal stress, expanding a temperature range to which the component is applicable, and enhancing reliability of the component. Specifically, the package structure needs to include a substrate, a package frame (window frame/lead-frame), and a pin (pin). The substrate is made of a metal material and bears thermal and electrical conductivity. The pin is for input/output of a signal and input/output of a power supply. The package frame is configured to bear the pin. The package frame is made of an insulation medium material and is located between the substrate and the pin, to avoid a short circuit connection between the substrate and the pin.

In a package process of the die, simplicity of the package process and reliability of pin welding are key factors, and a structure and a feature of the package structure play a decisive role in the package process. Currently, a ceramic material may be used as the package frame. The package frame encloses the die. The pin is disposed on the package frame. A bonding wire (bonding wire) is configured to connect the die and the pin, to lead out the internal circuit of the die. However, a ceramic-related process is complex, package costs are high, a pre-development periodicity is long, and a design is inflexible. A dielectric constant of the ceramic material is high, and a pin parasitic parameter is large.

Providing a package structure that simplifies a package process, reduces package costs, and improves package reliability is an important research in the art.

### SUMMARY

In view of the background, a first aspect of this application provides a package structure and a package method, to simplify a package process, reduce package costs, and improve package reliability.

To resolve the foregoing technical problem, the following technical solutions are used in this application.

A first aspect of this application provides a package structure. The structure includes a package substrate. The package substrate may be configured to bear a die. A printed circuit board may be disposed on the package substrate. The printed circuit board includes a board body and a metal pin on the board body. The board body is of an annular structure. The metal pin extends horizontally outside the board body and is configured to connect to an external circuit. The metal pin is further configured to connect to the die when the die is disposed on the package substrate exposed by the board body. In other words, in embodiments of this application, a package frame and a pin may be a printed circuit board. The printed circuit board includes a metal pin that may extend outside a board body, to implement an electrical connection between a die and an external circuit. Because manufacturing of the printed circuit board is simple, package costs are low. Because the package frame and the pin form an integrated structure, a package process is simplified.

In some possible implementations, a thickness range of the metal pin is 0.04 millimeter to 1 millimeter.

In this embodiment of this application, the thickness range of the metal pin may be limited, so that reliability of the metal pin can be ensured and the metal pin can have low rigidity, and stability of the package structure is improved.

In some possible implementations, a length range that the metal pin extends outside the board body is 0.2 millimeter to 20 millimeters.

In this embodiment of this application, the length range that the metal pin extends outside the board body may be limited, so that a connection length of the metal pin can be ensured and a bending requirement in some scenarios can be met, and the stability of the package structure is improved.

In some possible implementations, the metal pin is preformed to bend down.

In this embodiment of this application, the metal pin may be preformed to bend down, so that the metal pin can be welded to the external circuit with higher reliability, and a specific stress can be absorbed, thereby improving long-term reliability of a welding joint.

In some possible implementations, the board body includes a first part located on an upper surface of the package substrate and a second part located on at least one side wall of the package substrate, a structure of the first part is annular, and the first part and the second part form an integrated structure.

In this embodiment of this application, the board body may cover the upper surface of the package substrate and the at least one side wall, to implement a better protection effect on the package substrate, and provide reliable electrical isolation between the package substrate and the metal pin.

In some possible implementations, the printed circuit board further includes a metal wire on the board body.

In this embodiment of this application, the printed circuit board may further include the metal wire on a body of the printed circuit board, and the metal wire may be set based on an actual situation to meet a personalized requirement.

In some possible implementations, the package structure further includes a protective lid covering the printed circuit board.

In this embodiment of this application, the package structure further includes the protective lid, so that the printed circuit board can be integrally protected from above, and the reliability of the package structure is improved.

In some possible implementations, the substrate and the printed circuit board are bonded by using insulation gel.

In this embodiment of this application, the substrate and the printed circuit board may be bonded by using the insulation gel. In this way, costs are low, an operation is convenient, and reliability is high.

A second aspect of embodiments of this application provides a package method. The method includes:
fastening a die on a package substrate;
fastening a printed circuit board on the package substrate, where the printed circuit board includes a board body and a metal pin on the board body, the board body is of an annular structure, the die is disposed on the package substrate exposed by the board body, and the metal pin extends horizontally outside the board body and is configured to connect to an external circuit; and
connecting the metal pin and the die.

In some possible implementations, a thickness range of the metal pin is 0.04 millimeter to 1 millimeter.

In some possible implementations, a length range that the metal pin extends outside the board body is 0.2 millimeter to 20 millimeters.

In some possible implementations, the metal pin is preformed to bend down.

In some possible implementations, the board body includes a first part located on an upper surface of the package substrate and a second part located on at least one side wall of the package substrate, a structure of the first part is annular, and the first part and the second part form an integrated structure.

In some possible implementations, the printed circuit board further includes a metal wire on the board body.

In some possible implementations, the method further includes:
disposing a protective lid that covers the printed circuit board on the printed circuit board.

In some possible implementations, the fastening a printed circuit board on the package substrate includes:
bonding the printed circuit board on the package substrate by using insulation gel.

It can be learned from the foregoing technical solutions that embodiments of this application have the following advantages.

Embodiments of this application provide a package structure and a package method. The package structure may include a package substrate. The package substrate may be configured to bear a die. A printed circuit board may be disposed on the package substrate. The printed circuit board includes a board body and a metal pin on the board body. The board body is of an annular structure. The metal pin extends horizontally outside the board body and is configured to connect to an external circuit. The metal pin is further configured to connect to the die when the die is disposed on the package substrate exposed by the board body. In other words, in embodiments of this application, a package frame and a pin may be a printed circuit board. The printed circuit board includes a metal pin that may extend outside a board body, to implement an electrical connection between a die and an external circuit. Because manufacturing of the printed circuit board is simple, package costs are low. Because the package frame and the pin form an integrated structure, a package process is simplified.

### BRIEF DESCRIPTION OF DRAWINGS

To clearly understand specific implementations of this application, the following briefly describes accompanying drawings used for describing the specific implementations of this application. It is clear that the accompanying drawings show merely some embodiments of this application.
FIG. 1 is a schematic diagram of a current package structure;
FIG. 2 is a schematic diagram of a three-dimensional structure of a package structure according to an embodiment of this application;
FIG. 3 is a sectional view of the package structure shown in FIG. 2 along an AA direction;
FIG. 4 is a schematic diagram of another package structure according to an embodiment of this application;
FIG. 5 is a schematic diagram of forming a printed circuit board according to an embodiment of this application;
FIG. 6 is a schematic diagram of another type of forming a printed circuit board according to an embodiment of this application;
FIG. 7 is a schematic diagram of still another package structure according to an embodiment of this application;
FIG. 8 is a schematic diagram of yet another package structure according to an embodiment of this application;
FIG. 9 is a schematic diagram of still yet another package structure according to an embodiment of this application; and
FIG. 10 is a flowchart of a package method according to an embodiment of this application.

### DESCRIPTION OF EMBODIMENTS

Embodiments of this application provide a package structure and a package method to simplify a package process, reduce package costs, and improve package reliability.

In the specification, claims, and accompanying drawings of this application, the terms "first", "second", "third", "fourth", and the like (if existent) are intended to distinguish between similar objects but do not necessarily indicate a specific order or sequence. It should be understood that data termed in such a way is interchangeable in proper circumstances, so that embodiments described herein can be implemented in other orders than the order illustrated or described herein. Moreover, the terms "include", "have" and any other variants mean to cover the non-exclusive inclusion, for example, a process, method, system, product, or device that includes a list of steps or units is not necessarily limited to those steps or units, but may include other steps or units not expressly listed or inherent to such a process, method, product, or device.

This application is described in detail with reference to schematic diagrams. When embodiments of this application are described in detail, for ease of description, a sectional view indicating a structure of a component is partially enlarged not based on a general scale. In addition, the schematic diagrams are merely examples, and should not limit the protection scope of this application herein. In addition, three-dimensional space dimensions of a length, a width and a depth should be included in an actual production.

Currently, a ceramic material may be used as a package frame to form a ceramic package (ceramic package) structure. The package frame encloses a die. A pin is disposed on the package frame. A bonding wire is configured to connect the die and the pin, to lead out an internal circuit of the die. However, a ceramic-related process is complex, package costs are high, a pre-development periodicity is long, and a design is inflexible. A dielectric constant of a ceramic material is high, and a pin parasitic parameter is large. In addition, the pin needs to be additionally designed on the package frame, resulting in a complex process.

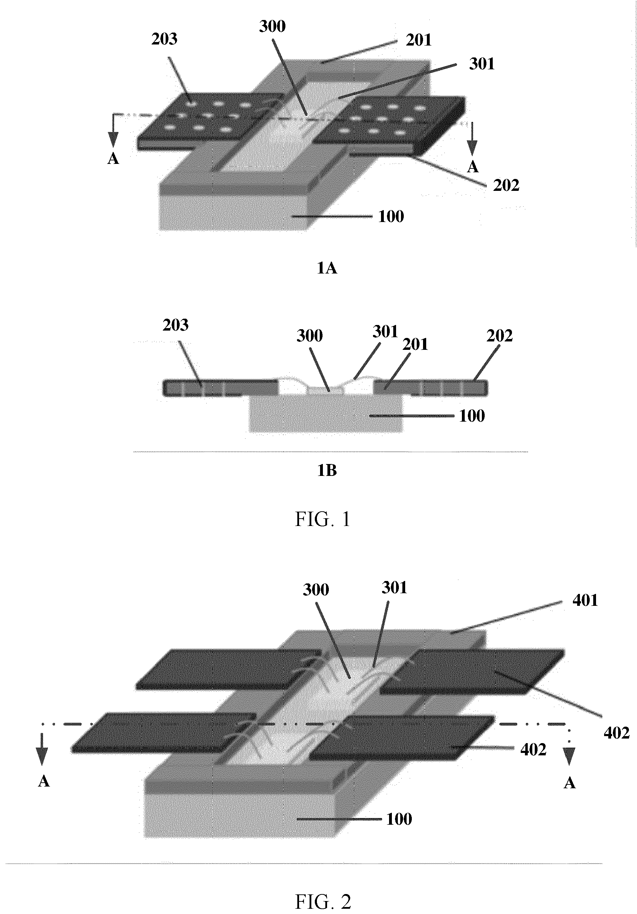

In addition, the package frame and a metal pin may alternatively be formed by using a printed circuit board (printed circuit board, PCB). FIG. 1 is a schematic diagram of a current package structure. FIG. 1B is a sectional view of the package structure in FIG. 1A along an AA direction. APCB board is disposed on a package substrate 100. The PCB board includes a dielectric layer 201 and a metal layer 202 on a surface of the dielectric layer 201. The dielectric layer 201 may be used as the package frame. A part of the PCB board protruding from the package substrate 100 forms a functional pin by using a metalized via 203 and a side metalized connection. The functional pin is configured to connect a die 300 to an external circuit, where the die 300 and the metal layer 202 are connected through a bonding wire 301. In some implementations, a plurality of PCB boards matches a height of the package substrate 100 to enclose the package substrate 100. The plurality of PCB boards are connected by welding.

The inventor finds through research that the pin part in the package structure includes the dielectric layer, and therefore, the pin has strong rigidity. This is unfavorable for absorbing a stress. The pin has a high reliability risk of board-level welding. Because the pin is a non-integrated conductive metal, an additional loss is increased. When the package substrate and the printed circuit board are connected through a welding process, reliability of the board-level welding is reduced. Therefore, providing a package structure that simplifies a package process, reduces package costs, and improves package reliability is an important research in the art.

Based on the foregoing technical problem, embodiments of this application provide a package structure and a package method. The package structure may include a package substrate. The package substrate may be configured to bear a die. A printed circuit board may be disposed on the package substrate. The printed circuit board includes a board body and a metal pin on the board body. The board body is of an annular structure. The metal pin extends horizontally outside the board body and is configured to connect to an external circuit. The metal pin is further configured to connect to the die when the die is disposed on the package substrate exposed by the board body. In other words, in embodiments of this application, a package frame and a pin may be a printed circuit board. The printed circuit board includes a metal pin that may extend outside a board body, to implement an electrical connection between a die and an external circuit. Because manufacturing of the printed circuit board is simple, package costs are low. Because the package frame and the pin form an integrated structure, a package process is simplified.

To make the objectives, features, and advantages of this application clearer and more comprehensible, the following describes specific implementations of this application in detail with reference to the accompanying drawings.

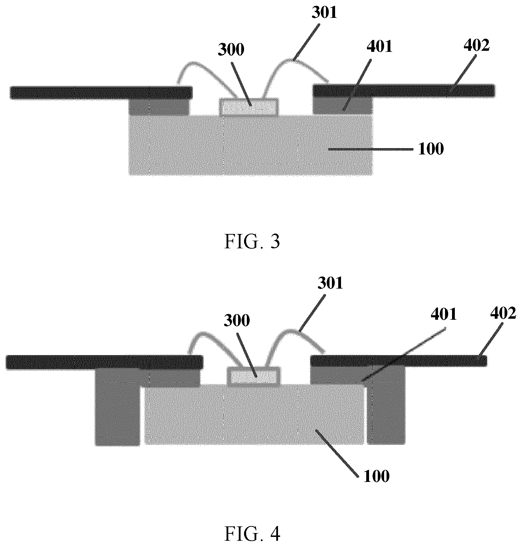

FIG. 2 is a schematic diagram of a three-dimensional structure of a package structure according to an embodiment of this application. FIG. 3 is a sectional view of the package structure shown in FIG. 2 along an AA direction. The package structure may include a package substrate 100 and a printed circuit board on the package substrate 100.

The package substrate 100 may also be referred to as a flange (flange), and is configured to bear a die 300. The package substrate 100 has structural stability. If a material of the package substrate 100 is a conductive material, the package substrate 100 may be used for grounding. The package substrate 100 may have a good heat dissipation effect. Therefore, the package substrate 100 may be used as a carrier for conducting electricity and heat.

The die 300 may be a die 300 with a radio frequency power amplification function, or may be another die 300 that needs to be packaged. When the die 300 is a die with a radio frequency power amplification function, a radio frequency power tube may be obtained by packaging the die 300. Usually, a package cost proportion of the radio frequency power tube cannot be ignored, and even is large. Therefore, a low-cost package is always a development object of the radio frequency power tube. In a radio frequency performance dimension, efficiency and bandwidth are key indicators of the radio frequency power tube. It is inevitable that the package brings some parasitic parameters. Optimizing this feature can reduce impact of some parameters and improve radio frequency power tube performance. Therefore, in a radio frequency power tube package process, a factor, for example, impedance matching, needs to be considered.

A printed circuit board may be disposed on the package substrate 100, where the printed circuit board may be used as a package frame and a pin. When the die 300 is fastened on the package substrate 100, the pin may implement leading out of a circuit structure of the die 300. The package frame may isolate the package substrate 100 from the pin, and the package frame may be of an annular structure, and encloses the die 300 to provide physical protection for the die 300. Costs of the printed circuit board are low. In addition, the printed circuit board with an integrated structure is used as the package frame and the pin, to reduce operation steps and package difficulty in the package process. Moreover, a size of the printed circuit board may be flexibly designed, and a design and manufacturing periodicity of the printed circuit board is short. Unlike a ceramic structure, the printed circuit board does not need mold making. This is beneficial to application and iteration of a product. The substrate and the printed circuit board may be bonded by using insulation gel. Costs are low, and a bonding process is simple.

Specifically, the printed circuit board may include a board body 401 and a metal pin 402 on the board body 401. The board body 401 may be of an annular structure. When the board body 401 is disposed on the package substrate 100, the board body 401 may cover a part of a surface of the package substrate, and expose an area enclosed by the annular structure. The metal pin 402 extends horizontally outside the board body 401, and forms a suspension design to connect to an external circuit. The metal pin 402 is further configured to connect to the die 300 when the die 300 is disposed on the package substrate 100 exposed by the board body 401, to lead out an internal circuit of the die 300. The metal pin 402 and the die 300 may be connected through a bonding wire 301.

A material of the board body 401 may be a dielectric material, and the dielectric material may be a material with a large dielectric constant. The board body 401 may be located only on an upper surface of the package substrate 100, and an outer side wall of the board body 401 is flush with an outer side wall of the package substrate 100. As shown in FIG. 2 and FIG. 3, the board body 401 may alternatively be slightly concave on the outer side wall of the package substrate 100.

In this embodiment of this application, the board body 401 may alternatively be located on the upper surface of the package substrate 100 and a side wall of the package substrate 100. FIG. 4 is a schematic diagram of another package structure according to an embodiment of this application. The board body 401 may include a first part located on the upper surface of the package substrate 100 and a second part located on at least one side wall of the package substrate 100. The first part and the second part are of an integrated structure, and a structure of the first part is annular. In this way, the board body 401 may enclose the side wall of the package substrate 100. The package substrate 100 is protected and structural stability of the package structure is improved. The second part located on the at least one side wall of the package substrate 100 may cover a side wall of an entire height of the package substrate 100, or may cover a side wall of a partial height of the package substrate 100. The structure of the board body 401 may be implemented by designing a length, a width, and a height of the board body 401. This has high flexibility. When a size of the package substrate 100 remains unchanged, a size of a package component may be flexibly designed by adjusting and designing a size of the board body 401.

A material of the metal pin 402 may be a metal material, and the metal material may be a material with good conductivity. Specifically, the metal pin 402 may include one metal material, or may include a plurality of metal materials. The metal pin 402 may be an integrated metal without another non-conductive material. Because the metal pin 402 is a metal structure on a surface of the board body 401, conductivity is good, an additional loss is small, and rigidity of the metal structure is small. This can improve stress absorption of the pin, and improve reliability of the package structure.

The metal pin 402 and the board body 401 may form an integrated structure. Specifically, the metal pin 402 may be combined with the board body 401 through integrated processing of the printed circuit board. An integrated processing process of the printed circuit board includes but is not limited to crimping, bonding, welding, and the like. A shape of the metal pin 402 may be designed by etching a metal material on the board body 401, and a suspension design of the metal pin 402 can be implemented by etching the board body 401. Therefore, an existing process can be better matched, and high operability and convenience are achieved.

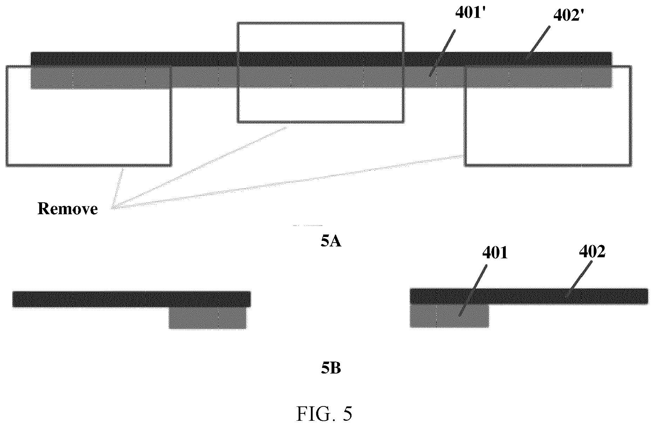

FIG. 5 is a schematic diagram of forming a printed circuit board according to an embodiment of this application. A board body layer 401' and a metal layer 402' on the board body layer 401' may be provided. As shown in FIG. 5A, a metal pin 402 may be obtained by etching the metal layer 402'. A center part and an outer ring part of the board body layer 401' are removed, so that a board body 401 of an annular structure can be formed and the metal pin 402 is disposed in a suspended manner. In this way, as shown in FIG. 5B, a printed circuit board that may be disposed on a package substrate 100 is obtained. In FIG. 5A, an area in a box indicates a part that needs to be removed, areas of a left box and a right box indicate the board body layer 401' of an outer ring, and an area of a middle box indicates a central metal layer 402' and a central board body layer 401'. Widths of the removed board body layer 401' and the removed metal layer 402' are determined based on actual situations such as a required width of a metal pin, a size of a package substrate, and a quantity of dies.

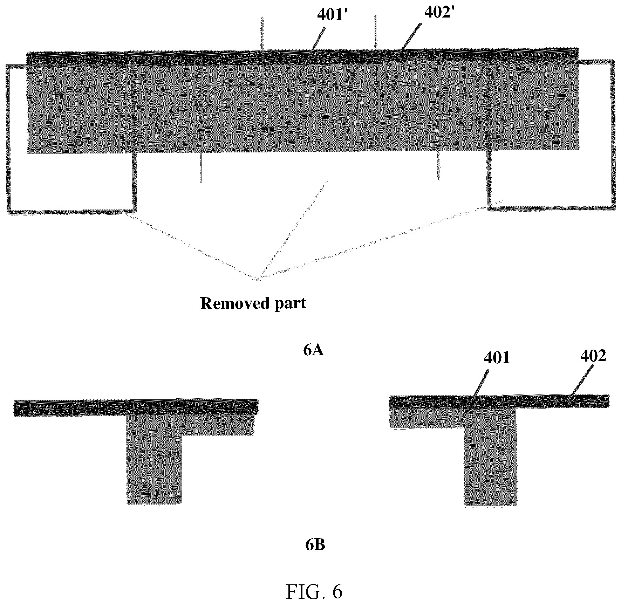

FIG. 6 is a schematic diagram of another type of forming a printed circuit board according to an embodiment of this application. A board body layer 401' and a metal layer 402' on the board body layer 401' may be provided. As shown in FIG. 6A, a metal pin 402 may be obtained by etching the metal layer 402'. A center part and an outer ring part of the board body layer 401' are removed, so that a board body 401 of an annular structure can be formed and the metal pin 402 is disposed in a suspended manner. As shown in FIG. 6B, thinning is performed on a middle part of the board body layer 401' to obtain a groove that can be embedded in a package substrate 100, and obtain a printed circuit board that can be disposed on the package substrate 100 and that encloses the package substrate 100. In FIG. 6A, an area in a box and an area between fold lines indicate a part that needs to be removed, areas in which a left box and a right box are located indicate the board body layer 401' of an outer ring, and the area between middle fold lines indicates a central metal layer 402' and a central board body layer 401'. A thinning thickness of the board body layer 40 1' may be determined based on a thickness of the package substrate 100, and widths of the removed board body layer 401' and the removed metal layer 402' are determined based on actual situations such as a required width of a metal pin, a size of a package substrate, and a quantity of dies.

Usually, a metal layer on a printed circuit board is thin and cannot be used as a pin. In this embodiment of this application, a thickening design may be performed on the metal layer on the printed circuit board, to improve structural stability of the metal pin 402 and improve a bonding force between the metal layer and a dielectric layer of the board body 401. Specifically, a thickness range of the metal pin 402 is 0.04 millimeter to 1 millimeter, and a length range that the metal pin 402 extends outside the board body 401 is 0.2 millimeter to 20 millimeters.

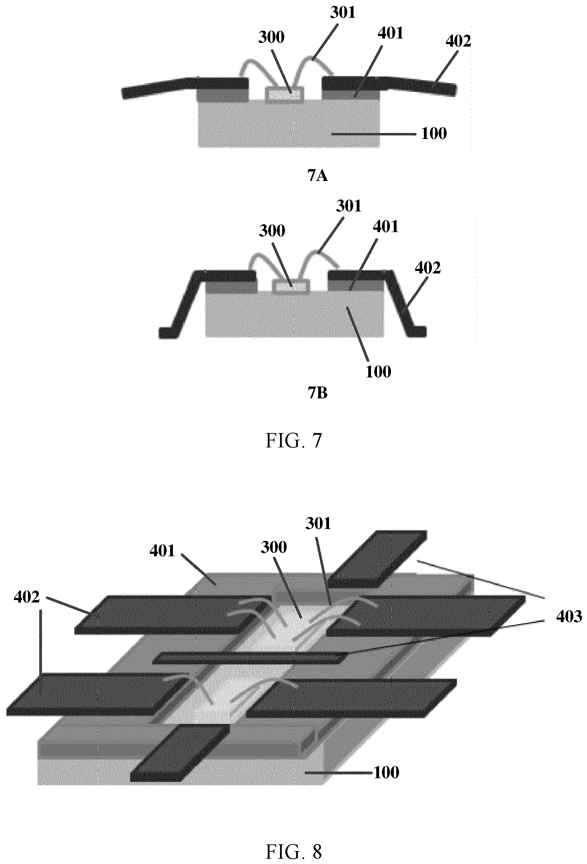

In addition, because the metal pin 402 has small rigidity and may be bent to bear a stress, the metal pin 402 may be further preformed to bend down. In this way, the metal pin 402 can be welded to an external circuit with higher reliability, and a specific stress can be absorbed, thereby improving long-term reliability of a welding joint. FIG. 7 is a schematic diagram of still another package structure according to an embodiment of this application. After a metal pin 402 is preformed, the metal pin 402 is bent down. Different bending degrees are applicable to board-level applications with different requirements. The metal pin 402 in FIG. 7A is applicable to a sinking type of welding. To be specific, a package substrate 100 is immersed in a connecting board, so that a welding joint is higher than a lower surface of the package substrate 100. The metal pin 402 in FIG. 7B is applicable to a surface-mount type of welding. To be specific, a package substrate 100 is disposed on a connecting board, so that a welding joint is flush with a lower surface of the package substrate 100.

In this embodiment of this application, the printed circuit board may further include a metal wire 403 on the board body 401. The metal wire 403 and the metal pin 402 may be formed at the same time. The metal wire 403 may be set based on an actual requirement, to expand performance of the package structure. For example, FIG. 8 is a schematic diagram of yet another package structure according to an embodiment of this application. A metal wire 403 may be disposed between two dies 300, to shield a radio frequency signal between the two dies 300. Alternatively, the metal wire 403 may be disposed outside the two dies 300, to change a surrounding electric field.

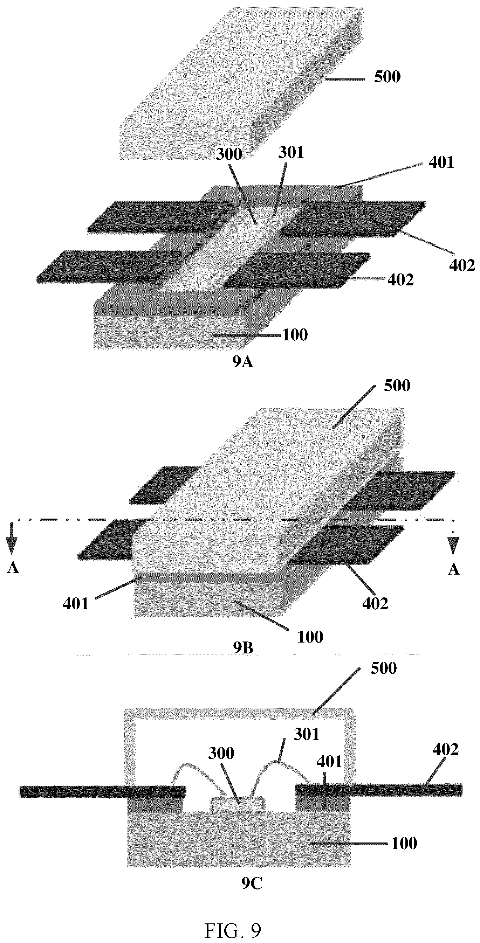

In this embodiment of this application, a protective lid (lid) 500 may be further disposed on the printed circuit board. FIG. 9 is a schematic diagram of still yet another package structure according to an embodiment of this application. FIG. 9A is a separate schematic diagram of the printed circuit board and the protective lid 500. The protective lid 500 may be pressed down on the printed circuit board and fastened to cover the printed circuit board. FIG. 9B is an overall schematic diagram of the printed circuit board and the protective lid 500. FIG. 9C shows a sectional view of the package structure in FIG. 9B along an AA direction. The protective lid may be of a hollow structure to accommodate a die and a bonding wire therein. The protective lid 500 may provide physical protection for the die 300 on the package substrate 100. The protective lid 500 has no function and requirement for electrical performance, and may be an insulation material.

Embodiments of this application provide a package structure. The structure may include a package substrate. The package substrate may be configured to bear a die. A printed circuit board may be disposed on the package substrate. The printed circuit board includes a board body and a metal pin on the board body. The board body is of an annular structure. The metal pin extends horizontally outside the board body and is configured to connect to an external circuit. The metal pin is further configured to connect to the die when the die is disposed on the package substrate exposed by the board body. In other words, in embodiments of this application, a package frame and a pin may be a printed circuit board. The printed circuit board includes a metal pin that may extend outside a board body, to implement an electrical connection between a die and an external circuit. Because manufacturing of the printed circuit board is simple, package costs are low. Because the package frame and the pin form an integrated structure, a package process is simplified.

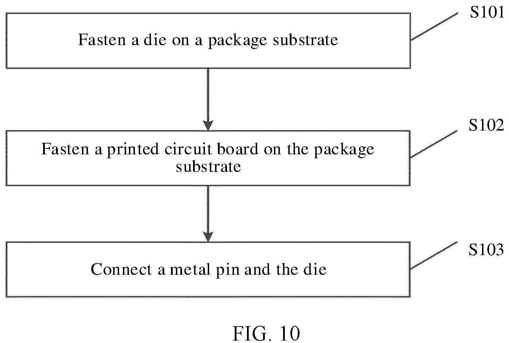

Based on the package structure provided in embodiments of this application, an embodiment of this application further provides a package method. FIG. 10 is a flowchart of a package method according to an embodiment of this application. The method may include the following steps.

S101: Fasten a die 300 on a package substrate 100.

The package substrate 100 may also be referred to as a flange (flange), and is configured to bear the die 300. The package substrate 100 has structural stability. If a material of the package substrate 100 is a conductive material, the package substrate 100 may be used for grounding. The package substrate 100 may have a good heat dissipation effect. Therefore, the package substrate 100 may be used as a carrier for conducting electricity and heat.

The die 300 may be a die 300 with a radio frequency power amplification function, or may be another die 300 that needs to be packaged. In a radio frequency power tube package process, a factor, for example, impedance matching, needs to be considered.

The die 300 may be fastened on the package substrate 100 in a bonding manner.

S102: Fasten a printed circuit board on the package substrate 100.

The printed circuit board may be disposed on the package substrate 100, where the printed circuit board may be used as a package frame and a pin. When the die 300 is fastened on the package substrate 100, the pin may implement leading out of a circuit structure of the die 300. The package frame may isolate the package substrate 100 from the pin, and the package frame may be of an annular structure, and encloses the die 300 to provide physical protection for the die 300. The substrate and the printed circuit board may be bonded by using insulation gel. Costs are low, and a bonding process is simple.

Specifically, the printed circuit board may include a board body 401 and a metal pin 402 on the board body 401. The board body 401 may be of an annular structure. When the board body 401 is disposed on the package substrate 100, the board body 401 may cover a part of a surface of the package substrate, and expose an area enclosed by the annular structure. The metal pin 402 extends horizontally outside the board body 401, and forms a suspension design to connect to an external circuit. The metal pin 402 is further configured to connect to the die 300 when the die 300 is disposed on the package substrate 100 exposed by the board body 401, to lead out an internal circuit of the die 300.

A material of the board body 401 may be a dielectric material, and the dielectric material may be a material with a large dielectric constant. The board body 401 may be located only on an upper surface of the package substrate 100, and an outer side wall of the board body 401 is flush with an outer side wall of the package substrate 100. As shown in FIG. 2 and FIG. 3, the board body 401 may alternatively be slightly concave on the outer side wall of the package substrate 100.

In this embodiment of this application, the board body 401 may alternatively be located on the upper surface of the package substrate 100 and a side wall of the package substrate 100. In this case, the board body 401 may include a first part located on the upper surface of the package substrate 100 and a second part located on at least one side wall of the package substrate 100. The first part and the second part are of an integrated structure, and a structure of the first part is annular. In this way, the board body 401 may enclose the side wall of the package substrate 100. The package substrate 100 is protected and structural stability of the package structure is improved, as shown in FIG. 4. The second part located on the at least one side wall of the package substrate 100 may cover a side wall of an entire height of the package substrate 100, or may cover a side wall of a partial height of the package substrate 100. The structure of the board body 401 may be implemented by designing a length, a width, and a height of the board body 401. This has high flexibility. When a size of the package substrate 100 remains unchanged, a size of a package component may be flexibly designed by adjusting and designing a size of the board body 401.

A material of the metal pin 402 may be a metal material, and the metal material may be a material with good conductivity. Specifically, the metal pin 402 may include one metal material, or may include a plurality of metal materials. The metal pin 402 may be an integrated metal without another non-conductive material. Because the metal pin 402 is a metal structure on a surface of the board body 401, conductivity is good, an additional loss is small, and rigidity of the metal structure is small. This can improve stress absorption of the pin, and improve reliability of the package structure.

The metal pin 402 and the board body 401 may form an integrated structure. Specifically, the metal pin 402 may be combined with the board body 401 through integrated processing of the printed circuit board. An integrated processing process of the printed circuit board includes but is not limited to crimping, bonding, welding, and the like. A shape of the metal pin 402 may be designed by etching a metal material on the board body 401, and a suspension design of the metal pin 402 can be implemented by etching the board body 401. Therefore, an existing process can be better matched, and high operability and convenience are achieved.

Usually, a metal layer on a printed circuit board is thin and cannot be used as a pin. In this embodiment of this application, a thickening design may be performed on the metal layer on the printed circuit board, to improve structural stability of the metal pin 402 and improve a bonding force between the metal layer and a dielectric layer of the board body 401. Specifically, a thickness range of the metal pin 402 is 0.04 millimeter to 1 millimeter, and a length range that the metal pin 402 extends outside the board body 401 is 0.2 millimeter to 20 millimeters.

In addition, because the metal pin 402 has small rigidity and may be bent to bear a stress, the metal pin 402 may be further preformed to bend down. In this way, the metal pin 402 can be welded to an external circuit with higher reliability, and a specific stress can be absorbed, thereby improving long-term reliability of a welding joint. As shown in FIG. 7, after the metal pin 402 is preformed, the metal pin 402 is bent down. Different bending degrees are applicable to board-level applications with different requirements.

The printed circuit board may further include a metal wire 403 on the board body 401. The metal wire 403 and the metal pin 402 may be formed at the same time. The metal wire 403 may be set based on an actual requirement, to expand performance of the package structure.

S103: Connect the metal pin 402 and the die 300.

In this embodiment of this application, after the die 300 is fastened on the package substrate 100, a connection between the die 300 and the metal pin 402 may be implemented by using a bonding wire.

In this embodiment of this application, a protective lid 500 may be further disposed on the printed circuit board. The protective lid 500 may provide physical protection for the die 300 on the package substrate 100. The protective lid may be of a hollow structure to accommodate a die and a bonding wire therein. The protective lid 500 has no function and requirement for electrical performance, and may be an insulation material.

Embodiments of this application provide a package method. A die may be fastened on a package substrate. A printed circuit board is fastened on the package substrate. The printed circuit board includes a board body and a metal pin on the board body. The board body is of an annular structure. The die is disposed on the package substrate exposed by the board body. The metal pin extends horizontally outside the board body and is configured to connect to an external circuit. The metal pin and the die are connected. In other words, in embodiments of this application, a package frame and a pin may be a printed circuit board. The printed circuit board includes a metal pin that may extend outside a board body, to implement an electrical connection between a die and an external circuit. Because manufacturing of the printed circuit board is simple, package costs are low. Because the package frame and the pin form an integrated structure, a package process is simplified.

Embodiments in this specification are all described in a progressive manner, for same or similar parts in embodiments, reference may be made to these embodiments, and each embodiment focuses on a difference from other embodiments. Especially, a method embodiment is basically similar to a structure embodiment, and therefore is described briefly; for related parts, reference may be made to partial descriptions in the structure embodiment.

The foregoing provides specific implementations of this application. It should be understood that the foregoing embodiments are merely intended for describing the technical solutions of this application, but not for limiting this application. Although this application is described in detail with reference to the foregoing embodiments, persons of ordinary skill in the art should understand that they may still make modifications to the technical solutions described in the foregoing embodiments or make equivalent replacements to some technical features thereof, without departing from the scope of the technical solutions of embodiments of this application.

## Claims

1. A package structure, comprising:
a package substrate, wherein the package substrate is configured to bear a die; and
a printed circuit board on the package substrate, wherein the printed circuit board comprises a board body and a metal pin on the board body, the board body is of an annular structure, the metal pin extends horizontally outside the board body and is configured to connect to an external circuit, and the metal pin is further configured to connect to the die when the die is disposed on the package substrate exposed by the board body.

2. The package structure according to claim 1, wherein a thickness range of the metal pin is 0.04 millimeter to 1 millimeter.

3. The package structure according to claim 1 or 2, wherein a length range that the metal pin extends outside the board body is 0.2 millimeter to 20 millimeters.

4. The package structure according to any one of claims 1 to 3, wherein the metal pin is preformed to bend down.

5. The package structure according to any one of claims 1 to 4, wherein the board body comprises a first part located on an upper surface of the package substrate and a second part located on at least one side wall of the package substrate, a structure of the first part is annular, and the first part and the second part form an integrated structure.

6. The package structure according to any one of claims 1 to 5, wherein the printed circuit board further comprises a metal wire on the board body.

7. The package structure according to any one of claims 1 to 6, wherein the structure further comprises a protective lid covering the printed circuit board.

8. The package structure according to any one of claims 1 to 7, wherein the substrate and the printed circuit board are bonded by using insulation gel.

9. A package method, comprising:
fastening a die on a package substrate;
fastening a printed circuit board on the package substrate, wherein the printed circuit board comprises a board body and a metal pin on the board body, the board body is of an annular structure, the die is disposed on the package substrate exposed by the board body, and the metal pin extends horizontally outside the board body and is configured to connect to an external circuit; and
connecting the metal pin and the die.

10. The package method according to claim 9, wherein a thickness range of the metal pin is 0.04 millimeter to 1 millimeter.

11. The package method according to claim 9 or 10, wherein a length range that the metal pin extends outside the board body is 0.2 millimeter to 20 millimeters.

12. The package method according to any one of claims 9 to 11, wherein the metal pin is preformed to bend down.

13. The package method according to any one of claims 9 to 12, wherein the board body comprises a first part located on an upper surface of the package substrate and a second part located on at least one side wall of the package substrate, a structure of the first part is annular, and the first part and the second part form an integrated structure.

14. The package method according to any one of claims 9 to 13, wherein the printed circuit board further comprises a metal wire on the board body.

15. The package method according to any one of claims 9 to 14, wherein the method further comprises:
disposing a protective lid that covers the printed circuit board on the printed circuit board.

16. The package method according to any one of claims 9 to 15, wherein the fastening a printed circuit board on the package substrate comprises:
bonding the printed circuit board on the package substrate by using insulation gel.
